# EUROPEAN PATENT APPLICATION

(11) **EP 1 462 809 A1**
(43) Date of publication of application: **29.09.2004**
(21) Application number: 04251391.1
(22) Date of filing: 10.03.2004
(51) Int. Cl.: G01R 13/32, G01R 13/34, G01R 13/26

(54) **Automated ranking and storage of unique waveforms in oscilloscopes**

(30) Priority: 27.03.2003 US 402626
(71) Applicant: Tektronix Inc., Beaverton Oregon 97077-0001 (US)
(72) Inventor: Azinger, Frederick A., Portland Oregon 97231 (US)
(74) Representative: Burke, Steven David

(57) **Abstract**

A system for determining which waveforms should be preserved in memory (22) for eventual display by an oscilloscope. An input signal (1) is processed by a rasterizer (14). A pixel counter (15) monitors the frequency of usage of each pixel available for display in the rasterized image, and a unique waveform threshold calculator (24) compares pixel utilization during an image acquisition period. The calculator (24) identifies those waveforms that deviate significantly from the normal input signal waveform (1) and sends them to a scoring processor (21) which assigns each unique waveform (2) a value indicative of the magnitude of its deviation from previous waveforms. The scoring processor (21) also compares the scores of each unique waveform and assigns a ranking to each waveform. The lowest ranking waveform is overwritten in its segment of memory (22) as waveforms with higher rankings are processed.

## Description

### FIELD OF THE INVENTION

This invention relates generally to the field of oscilloscope display systems, and more particularly to a system for identifying and segregating anomalous data.

### BACKGROUND OF THE INVENTION

Current digital storage oscilloscopes can create images derived from variable, asymmetric and short lived signals. Display of the signal cannot fully reflect all of the information contained in the input signal if signal magnitudes, frequencies, phase relationships and the presence or absence of the signal are irregular. Since the signal characteristics are not usually known in advance, the memory allocation in a digital storage oscilloscope, if allocated uniformly throughout each signal sampling period, will typically allocate most of the memory to somewhat repetitive signal conditions while allocating a disproportionately small amount of memory to anomalous events which often tend to be of most interest to the user.

Ideally, the oscilloscope signal processing circuitry should have some means of identifying dramatic input signal changes that are indicative of unusual signal variations. An example of an oscilloscope which addresses this problem is disclosed in U.S. Patent No. 5,438,531 entitled ZERO DEAD TIME ACQUISITION FOR A DIGITAL STORAGE OSCILLOSCOPE, issued on August 1, 1995 to Shank. The Shank device stores an initial signal characteristic value from an acquisition memory for each sample interval of an input analog signal. Each successive incoming waveform is compared to the stored signal characteristic and, if the new signal is sufficiently different from the stored signal, the new signal is saved and signal acquisition ceases. This method of oscilloscope signal evaluation is known as the "save on delta" approach. In this manner the Shank device attempts detect and ultimately display rare, anomalous and nonrepetitive events.

Many oscilloscopes have the ability to segment or compartmentalize their memory systems in order to save multiple signal acquisitions. For example, if a user is trying to observe a signal characterized by many rapid, high amplitude, short duration pulses, such as a spark, radar or laser emission, each measurable event is occurring so rapidly that each waveform must be stored in memory for future analysis since real time processing would be impossible. An example of such segmented or multiple memory allocation is disclosed in U.S. Patent No. 5,740,064 entitled SAMPLING TECHNIQUE FOR WAVEFORM MEASURING INSTRUMENTS, issued on April 14, 1998 to Witte et al. The Witte et al. device extracts a decimated sample value from each decimated sample interval while simultaneously determining the maximum and minimum signal values during that interval. In one operating mode, if the difference between the maximum and minimum values exceeds a predetermined threshold, the maximum and minimum values are transferred to a video sample memory in what is called the "decide, then store" method. In another operating mode the data is stored in multiple memories for later determination of maxima and minima in what is called the "store, then decide" approach. This is a characteristic of many batch data capture, post signal processing schemes.

Many state of the art oscilloscopes accumulate the results of many signal acquisition periods to form a displayable raster image, thereby superimposing many signal acquisitions over each other. As these signal traces are overlaid, the intensity of each trace is adjusted to give the user information about the frequency of occurrence of each particular waveform. An example of such a device is disclosed in U.S. Patent No. 6,188,384, entitled REACTING TO UNUSUAL WAVEFORMS, issued on February 13, 2001 to Sullivan et al. Unusual waveforms are defined in terms of how many new pixels are affected by the process of rasterizing them. New pixels can be those not yet affected by the rasterization of any waveform in the current set of signal acquisitions, or can be those pixels that have had higher values in their raster memory location but have since decayed below a predefined value. Once detected, such waveforms can be rerasterized with additional intensity or using a different color by using a reserved range of values stored in the raster memory. In the Sullivan et al. device, unusual waveforms can also be saved in long term memory.

While each of the aforementioned devices makes some attempt at differentiating between different incoming waveforms, what is desired is a system for actually capturing and eventually viewing anomalous circuit behavior not in hindsight, but in real time as the signal acquisition is taking place.

### SUMMARY OF THE INVENTION

The present invention addresses the problem of identifying, capturing and viewing atypical oscilloscope input signals. While prior art oscilloscopes have acquired and stored multiple input signal waveforms, the present invention identifies which waveforms should be preserved and which should be overwritten as memory resources become exhausted. When all memory segments are full, the prior art solution is to discard and overwrite the oldest waveform as measured in the time domain. The present invention utilizes other factors in identifying the best potential candidate waveforms for storage based on the uniqueness of the waveform when compared to the rasterized image that is being constructed by the oscilloscope image processing circuitry. These factors include the number of pixels utilized for the first time during the rasterization process, the frequency with which particular pixels are utilized, the total number of pixels being utilized for displaying a particular waveform, the variation in pixel utilization between succeeding waveforms and the concentration of pixel utilization in each quadrant or grid square of the image display area.

Each waveform is rated or scored in an absolute sense based on the above criteria, and then ranked in comparison to the preceding and following waveforms produced during a given period of signal acquisition. The score becomes one variable in an algorithm that manages memory segments. A higher score indicates a relatively more unique and anomalous waveform.

In allocating memory segment usage, the higher ranking waveforms are retained in memory in favor of lower ranking waveforms which are overwritten as the memory segments become unavailable. At the end of a signal acquisition period, the user is left with a selection of the relatively most unusual waveforms that were collected during that period.

### BRIEF DESCRIPTION OF THE DRAWING

Figure 1 is a conceptual block diagram showing how the present invention may be implemented in conjunction with conventional digital storage oscilloscope acquisition, rasterization and display functions;
Figure 2 is a diagrammatic representation view of the unique waveform storage memory depicted in Figure 1;
Figure 3 is a flow chart of some of the various steps involved in the automated storage technique disclosed herein;
Figure 4 is a display of a first typical waveform that may be characterized by the present invention; and
Figure 5 is a display of a second typical waveform that may be characterized by the present invention.

### DETAILED DESCRIPTION

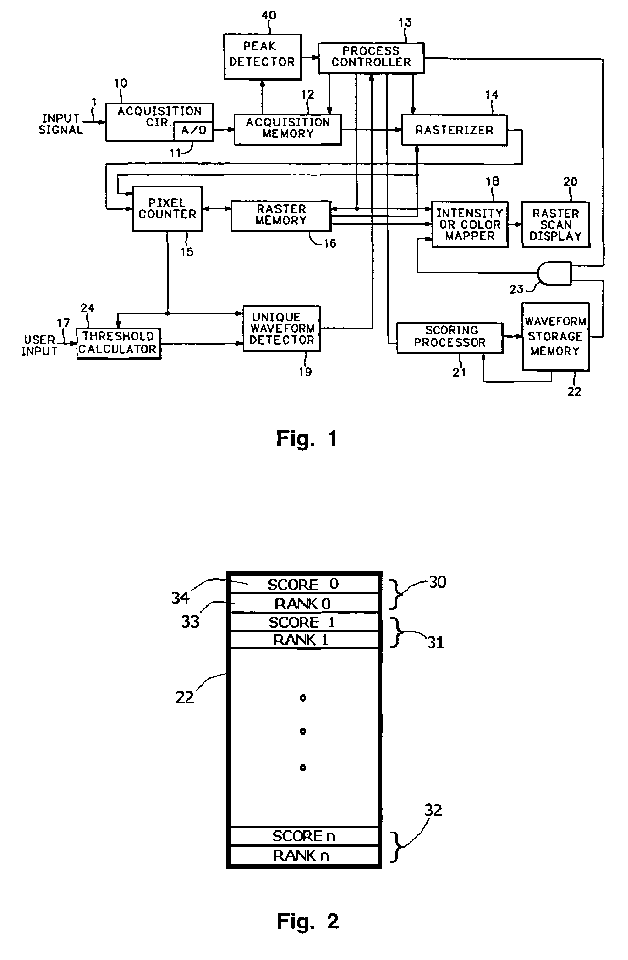

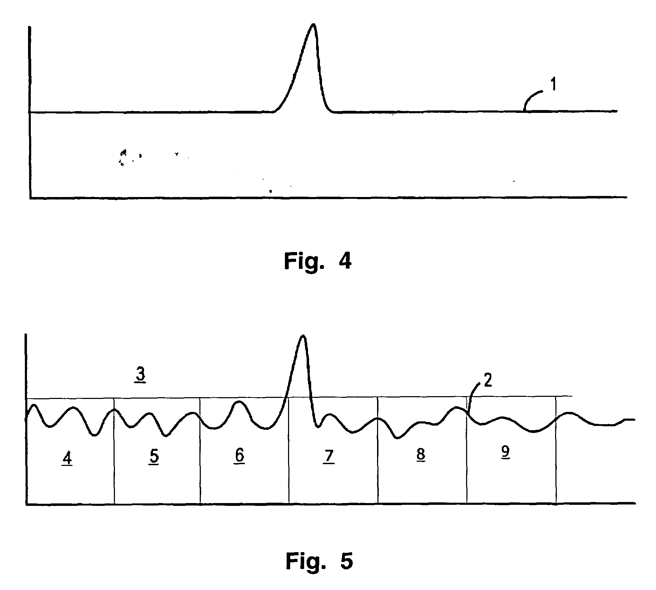

Referring to Figures 1 and 4, the system of the present invention begins with acquisition circuitry 10, which tracks and periodically samples an input signal 1 being monitored by the oscilloscope of which all of the circuitry shown in Figure 1 is a part. Analog to digital converter 11 produces as its output a stream of binary values describing the amplitude of the input signal tracked by the acquisition circuitry. These amplitude values are stored at sequentially related addresses in the acquisition memory 12. The resulting data address pairs are subsequently sent to rasterizer 14 according to directions from the process controller 13. The rasterizer 14 converts single data address pairs into a point or converts a sequential pair of data address pairs into a vector, mapping the resulting points into a two dimensional array of rows and columns that will eventually be displayed on raster display 20. The rasterizer 14 typically operates on one column of the raster at a time, performing read, modify and write operations on each memory location in the raster memory 16 that is affected by the current point or vector being generated. The process controller 13 operates to coordinate the activities of the acquisition memory 12, the rasterizer 14 and the raster memory 16. The intensity or color mapper 18 is programmed to map raster location stored values in the raster scan display 20. In an alternate embodiment of the present invention, the rasterizer 14, raster memory 16 and raster scan display 20 may be replaced by any image storing and display device that serves the function of a composite display memory and its associated display hardware. Similarly, the acquisition circuitry 10 can be any system that obtains new waveform data by any means, and is not limited to any particular analog or digital waveform acquisition protocol.

The pixel counter 15 records the number of pixels that are being accessed during the current waveform rasterization process that have never been accessed before by the current series of waveform acquisitions. As seen in Figure 4, this would include all of the pixels not residing on the trace of the displayed input signal 1. The pixel counter 15 uses a one bit pixel map dedicated to monitoring all of the pixels that have yet to be used. The pixel counter 15 also examines the frequency with which each pixel has been accessed during the current series of waveform acquisitions. The frequency count would include all of the pixels residing on the trace of the displayed input signal 1. This frequency is then compared to a reference value which is a measure of both how recently and how often within successive time periods any particular pixel has been accessed. The reference value may be set as low as zero, indicating that only pixels that have never been accessed should be recorded. The reference value may also be set to any positive number, indicating that pixels are of interest even if they have previously been accessed, but only if a relatively small number of times. If the frequency is above the reference value, this is an indication that the pixel is possibly associated with a relatively regular or static waveform, whereas a frequency below the reference value indicates that the pixel may be associated with a new or anomalous waveform or event, such as the signal 2 shown in Figure 5.

After each waveform rasterization, the pixel counter 15 forwards the number of pixels falling below the reference value to the unique waveform threshold calculator 24, and also to the unique waveform detector 19. The unique waveform threshold calculator 24 may or may not utilize user input 17 in formulating the unique waveform threshold value it provides to the unique waveform detector 19. The unique waveform detector compares the number of pixels that are above the unique waveform threshold to the number of pixels that are below the reference value. If a predetermined criterion is met, for example if the number of pixels below the reference value is greater than the unique waveform threshold, the unique waveform detector notifies the process controller 13 of this event.

The detection of a unique waveform 2 causes the process controller 13 to request that the acquisition memory 12 forward the data record that produced the unique waveform to a memory segment residing within storage memory 22. The unique waveform threshold calculator 24 is typically programmed to ignore the initial set of pixel data received at the beginning of a new series of data acquisitions. The purpose of discarding the data associated with the first waveforms is based on the knowledge that the first waveforms will be, by definition, unique and hence would inevitably be stored in memory 22. After the initial waveform data has been omitted from consideration by the unique waveform detector 19, enough waveform data will have been collected to define the baseline or typical pixel acquisition patterns. The baseline data can be used to calculate a mean and a standard deviation from that mean, and those values can then be used by calculator 24 to formulate a unique waveform threshold for use by detector 19.

Various approaches may be used to define the unique waveform threshold used by calculator 24. One method is for the user to directly set the threshold at some constant level, as might be appropriate if the nature of the anomalous data was well enough known that the deviation from the typical waveform could be readily characterized. Another method is to first determine the size of the initial set of waveforms to be discarded and then calculate the mean and standard deviation of the remaining waveforms. Alternatively, the number of waveforms used to define the mean can be preset. The calculator 24 can be programmed to consider a fixed number standard deviations, or fractions thereof, from the mean as typical or normal waveforms. Another method best seen in Figure 5 is to divide at least some of the available image area 3 into a series of shapes or sectors, such as grids 4, 5, 6, 7, 8 and 9, for example. The calculator can then view changes within grids, or between adjacent grids, to determine the likelihood that an anomalous waveform is being examined.

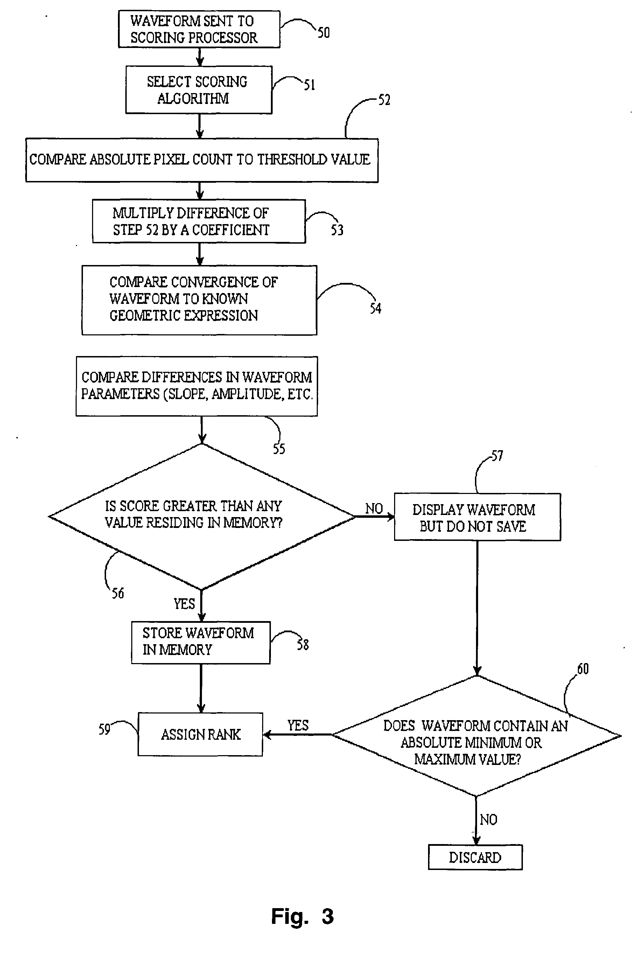

Referring also to Figures 2 and 3, once the unique waveform 2 has been identified, it is sent at step 50 to the scoring processor 21 in order to characterize its uniqueness with respect to other unique waveforms that have been stored in a segment of memory 22. The memory 22 is seen to contain accumulated unique waveform samples. The user may review each of the stored waveform samples based on any selected criteria, such as a uniqueness ranking or the time at which the waveform was acquired. The unique waveform samples represent data pairs that contain characterizing information created by scoring processor 21 concerning each waveform. The first stored waveform residing in memory segment 30 contains a raw score parameter 34 which is a numerical value representing the uniqueness of that waveform according to a scoring algorithm selected at step 51. At step 52 the algorithm may simply calculate the difference between that waveform and the uniqueness threshold as determined by calculator 24. Or, at step 53, the algorithm may take the magnitude of the waveform's departure from the uniqueness threshold and multiply it by a coefficient based on the absolute number of pixels that make up the waveform (with higher pixel counts receiving a higher score). At step 54, the coefficient or multiplier can be based on the convergence of the pixels with a known mathematical relationship (for example, y = mx + b; y = ax² + bx + c; y = 3, where convergence receives either a lower or higher score depending on user preference). At step 55, the multiplier is based on the variation of a single parameter, such as the slope m of a linear relationship or the eccentricity e of an ellipse. The limitations on such mathematical computations are limited only by the processing power of scoring processor 21 and overall time constraints. Since the uniqueness of the waveform has already been determined by the detector 19, the subsequent scoring or characterization of the waveform's uniqueness can consume some additional time in a post processing step without incurring a substantial penalty. The selection of the comparison criteria can be dynamic, so that once a unique waveform appears a certain number of times it is relegated to the status of normalcy, thereby permitting other waveforms to achieve a relatively higher score during subsequent sampling periods. The scoring criteria can be any waveform characteristic that is of interest to the user, and can include not only a unique characteristic of the waveform itself but may also be based on the relative time period during which the waveform occurred.

Once the scoring has been completed, at step 56 the scoring processor examines the score of the other unique waveforms 31, 32, etc., and then determines if the score of the current waveform exceeds the score of any waveform residing in memory 22. If not, the waveform is displayed at step 57 but is not saved in any segment of memory 22. If so, however, the lowest ranking waveform is deleted from memory 22 at step 58 in order to accommodate storage of the newest waveform. By comparing the raw score of the current waveform to the raw score of the other waveforms in memory 22, a ranking parameter 33 is assigned to the current waveform at step 59.

Assuming that the memory 22 contains one hundred individual memory segments, corresponding to one hundred individual unique waveforms, the waveforms having the top one hundred ranks will be available for viewing by the user on display 20 via AND gate 23. One particular parameter frequently of interest is the minimum and maximum value of the waveform. Even when a particular waveform is not inherently unique based on, for example, the pixel count or pixel location, that waveform may be of interest because it contains the greatest amplitude, has reached a zero crossing point, or has the largest absolute peak to peak value. The peak detector 40 as shown in Figure 1 determines the maximum and minimum values of each waveform. The ranking of a waveform containing the highest or lowest value can be selected by the user at step 60 to have a rank that will insure its residence in some segment of memory 22.

While a preferred embodiment of the present invention has been shown and described, it will be apparent to those skilled in the art that many changes and modifications may be made without departing from the invention in its broader aspects. For example, the threshold calculator 24 may be composed entirely of hardware, entirely of software, or some combination of both. Further, the rasterizer 14 and display 20 are not essential since the uniqueness data may be based on a waveform characteristic not directly related to the image, such as the rate of waveform rise or decay. The claims that follow are therefore intended to cover all such changes and modifications as are permitted by the patent laws of the respective countries in which this patent is granted.

## Claims

1. An apparatus for automatically storing unique waveform images to be presented on a display device, comprising:
an acquisition memory adapted to store an input signal;
a storage memory, the storage memory being interconnected to the acquisition memory, the storage memory retaining data representing at least one output image derived from the input signal;
a display memory, the display memory being interconnected to the storage memory, the display memory retaining data representing an output image to be presented on the display device; and
a scoring processor, the scoring processor being interconnected to the display memory, the scoring processor characterizing at least some characteristic of each output image data retained by the display memory.

2. The apparatus of claim 1 wherein the scoring processor applies a ranking criterion to each output image datum based on a user selected preference.

3. The apparatus of claim 2 wherein a lowest ranking output image residing in the storage memory is overwritten when a higher ranking output image is forwarded to the storage memory.

4. The apparatus of claim 3 further comprising a threshold calculator, the threshold calculator being adapted to calculate a difference between pixel usage characteristics of succeeding output images.

5. The apparatus of claim 4 wherein the threshold calculator determines when a difference between pixel usage characteristics of succeeding output images indicates some likelihood of an anomalous input signal.

6. The apparatus of claim 5, further comprising a process controller, the process controller being interconnected to the threshold calculator and the scoring processor, the processor controller being adapted to forward an output image to the scoring processor for quantifying at least some characteristic of output image pixel usage when the threshold calculator indicates some likelihood that the output image is associated with anomalous input signal.

7. The apparatus of claim 6, wherein the scoring processor creates a raw score parameter for each output image processed by the scoring processor.

8. The apparatus of claim 7 wherein the scoring processor modifies the raw score parameter for each output image based on total pixel usage of the output image.

9. The apparatus of claim 7 wherein the scoring processor modifies the raw score parameter of each output image in response to similarities to raw score parameters of previously processed output images.

10. The apparatus of claim 7 wherein the scoring processor modifies the raw score parameter of each output image in response to similarities to raw score parameters associated with known mathematical expressions.

11. An image acquisition and display system, comprising:
means for acquiring a series of successive waveforms;
a scoring processor, the scoring processor characterizing each waveform, the scoring processor assigning a rank to each waveform based on a characteristic of the waveform; and
a memory, the memory storing successive waveforms and the rank associated with each waveform.

12. The system of claim 11, further comprising a rasterizer, the rasterizer creating a composite image derived from each successive waveform.

13. The system of claim 12, wherein an input image residing in the memory and having a relatively lowest ranking is overwritten whenever an input image having a relatively higher ranking is forwarded to the memory by the scoring processor.

14. The system of claim 13 further comprising a peak detector, the peak detector determining maximum and minimum amplitude information of each input image and forwarding the amplitude information to the scoring processor.

15. The system of claim 14 wherein the scoring processor assigns a sufficiently high rank to an input image containing a maximum amplitude to ensure that the input image resides in the memory without being overwritten by subsequent input images.

16. The system of claim 15 further comprising a pixel counter, the pixel counter identifying each pixel that is used in rasterizing an input image.

17. The system of claim 16 further comprising a threshold calculator, the threshold calculator receiving pixel identification data from the pixel counter and calculating variations in pixel usage by succeeding input images.

18. A method of storing unique image data, comprising the steps of:
collecting image data from a plurality of successive images;
assigning a score to image data associated with each image;
ranking each image based on the score assigned to the image data; and
storing each image in a memory location according to the rank of the image.

19. The method of claim 18, further comprising the step of overwriting a lowest ranking image residing within the memory location when a relatively higher ranking image is presented for storage.

20. The method of claim 18, further comprising the step of permitting user access to each stored image.
